# EUROPEAN PATENT SPECIFICATION

(11) **EP 2 625 997 B1**
(45) Date of publication and mention of the grant of the patent: **19.03.2014**
(21) Application number: 13152932.3
(22) Date of filing: 28.01.2013
(51) Int. Cl.: A47L 15/42, H02M 7/00, H03H 1/00, H05K 1/02

(54) **Dish-washing machine**
Geschirrspülmaschine
Lave-vaisselle

(30) Priority: 07.02.2012 IT TO20120095
(43) Date of publication of application: 14.08.2013
(73) Proprietor: Indesit Company S.p.A., 60044 Fabriano (AN) (IT)
(72) Inventor: Ughetto, Fabio Alessio, 10094 Valgioie (TO) (IT); Marvardi, Giacomo, 06024 Gubbio (PG) (IT); Florian, Massimo, 10040 Rivalta di Torino (TO) (IT); Lippera, Mario, 60043 Cerreto d'Esi (AN) (IT); Benedetto, Gianluca, 07024 La Maddalena (OT) (IT)
(74) Representative: Santonicola, Paolo

(56) References cited:
- EP-A2- 2 332 456
- DE-A1- 10 218 863
- DE-A1-102004 057 007
- DE-A1-102007 030 064

## Description

### Field of the invention

The present invention relates to a dish-washing machine having a structure that comprises a wash tub made of metal material supported by a base made of plastic material, the base having a plurality of peripheral walls that define a housing space for housing a plurality of electrical loads that can be supplied via a supply cable for connection to an a.c. electric mains supply, wherein provided between the supply cable and the plurality of electrical loads is a filter device that includes a common-mode filter having an earthing connection.

### State of the art

Dishwashers - like other electrical and electronic appliances in general - produce in normal operation electromagnetic disturbance that can propagate along the conductors (guided propagation) or in free space (radiated propagation).

For the above reasons, electrical household appliances, including dishwashers, must satisfy certain criteria of electromagnetic compatibility (EMC), established by relevant standards (such as EN 61000-3-2, EN 61000-3-3, EN 55104-1, and EN 55014-2). In general terms, a dishwasher should be able to function properly in its electromagnetic environment without introducing any disturbance that might interfere with operation of other equipment or systems present in the same environment.

For the purposes of certification, dishwashers - like other electrical household appliances - must undergo conducted-emission tests and disturbance-power tests. Conducted-emission tests basically consist in measuring the disturbance currents introduced by the machine in the electric mains to which it is connected. The measurement of conducted emission is made between 150 kHz and 30 MHz and is expressed in dBµV; what is measured is the effect of a disturbance current on a known load (hence a voltage). Given that the aim is to measure a disturbance current, the measurement is made for all the connections that deliver power to the electrical household appliance and hence, in the case of a dishwasher, for live and neutral. The disturbance-power tests, unlike the conducted-emission tests, consist in measuring a power irradiated by the supply cable of the electrical household appliance, measured in dBpW. The range of frequencies to be investigated is comprised between 30 and 300 MHz.

The electronic card that superintends general control of the dishwasher is generally the main source of high-frequency disturbance. To minimize the emission of said disturbance it is obviously possible to intervene at various levels, starting from a good design of the layout of the electronic control card according to appropriate methodologies. This is not, however, always sufficient, and for this reason the machine must be equipped with an anti-noise filter device, which constitutes a final interface between the supply cable of the dishwasher (i.e., between the external supply line) and the internal electrical circuit of the dishwasher itself.

The filter device should ideally be as close as possible to the input point of the supply cable in the structure of the dishwasher. For this reason, usually the filter device is fixed inside the base, on its rear wall, precisely in a position substantially corresponding to the point of entry of the supply cable into the structure. The electronic control card of the machine is, conversely, usually positioned in the proximity of the front of the base, for questions of encumbrance, protection, and easier accessibility in the case of possible interventions of maintenance and/or repair. This means that extending between the filter device (i.e., the point of entry of the supply cable into the structure of the machine) and the electronic card are electric conductors, which may function as elements that capture electromagnetic disturbance. One function of the filter device is to prevent the aforesaid disturbance from being injected into the external electrical mains supply.

It is certainly possible to position the electronic card directly in the proximity of the point of entry of the supply cable into the machine, and possibly implement thereon the functions of the filter device. In a known machine, for example, the electronic card is set at one side of the base, and mounted thereon are both the filter device and a series of ferrites that enable abatement at the origin of the electromagnetic noise generated by the card. This type of solution considerably complicates production of the card, burdening its circuit arrangement and increasing its overall dimensions and overall cost. The encumbrance of the card implies that it must be positioned at one side of the base, with the consequence that the supply cable penetrates into the structure of the machine laterally, with drawbacks of a practical nature (above all if it is considered that frequently dishwashers must be built-in inside kitchen cabinets or set alongside other cabinets or electrical household appliances). The lateral position of the card may also complicate possible interventions of maintenance and jeopardize the possibility of location of other functional components of the machine in the base.

As has been said, more commonly, the filter device is mounted on the back of the base and is typically made up of passive components, such as capacitors, inductors, ferrites, resistors. The disturbance that such a filter device has to attenuate is fundamentally of two types: common-mode disturbance and differential-mode disturbance. Common-mode filtering usually includes two capacitors connected between the earth and live and neutral, respectively. In the ideal case, each capacitor works as low-pass filter and cuts off the high-frequency disturbance present on the live to which it is connected.

In the case of machines with a base made of metal material an efficient earthing connection of the chassis of the machine may be made exploiting its connection to the base, and hence the proximity to the filter device. Instead, in the case of machines with a plastic base, the earth connection of the chassis is obtained via an electric wire connected to a metal component of the structure supported by the base, typically represented by one of the hinges of the door of the electrical household appliance. This earth connection, which also performs functions of electrical safety, implies the presence of a relatively long connection wire, which extends between the back and the front of the base. An example of this known earth connection may be found in the dishwashing machine manufactured by Indesit Company S.p.A. and marketed with the commercial code LFT 321 HX/HA.

This type of connection is not a source of particular problems as regards low-frequency disturbance, but may be such as regards high-frequency disturbance. In fact, the earthing efficiency, for the purposes of filtering of disturbance, decreases as the frequency of disturbance increases. This also occurs on account of the known "skin effect", i.e., the tendency of the high-frequency electric current to distribute in a nonuniform way over the section of a circular conductor, concentrating on its outer surface, with the consequence that, as the frequency increases, the resistance of the conductor increases, thus worsening the quality of the connection.

For this reason, along the wiring that extends within the base, including the electrical earthing wire, there are usually set ferrites, i.e., rings made of a material with a high degree of magnetic permeability, which themselves form filters that neutralize any disturbance locally.

### Summary and object of the invention

With a view to what has been set forth above, the aim of the present invention is to provide a dish-washing machine in which the emission of high-frequency disturbance introduced into the corresponding external electrical mains supply may be significantly reduced in a simple and inexpensive way.

The above and other objects still that will emerge more clearly hereinafter are achieved according to the present invention by a dish-washing machine having the characteristics referred to in the annexed claims, which form part of the technical teaching provided herein in relation to the invention.

### Brief description of the drawings

The objects, characteristics, and advantages of the present invention will emerge clearly from the ensuing description, with reference to the annexed drawings, which are provided purely by way of non-limiting example and in which:
- Figure 1 is a partial and schematic perspective view of a dishwasher according to the present invention;
- Figure 2 is an exploded view of some components, represented partially, of the dishwashers of Figure 1;
- Figure 3 is a simplified circuit diagram of a filter device of a dishwasher according to the invention;
- Figures 4, 5 and 6 are a perspective view, a view in side elevation, and a view in front elevation of a metal contact strap used in a first embodiment of the invention;
- Figure 7 is a partial and schematic view in side elevation of the components of the dishwashers of Figure 2;
- Figure 8 is a front elevation, according to the line VIII of Figure 7;
- Figure 9 is a perspective view of the components of Figures 7 and 8;
- Figure 10 is an enlarged detail of Figure 8;
- Figure 11 is a partial and schematic perspective view of a base of a dishwasher in accordance with a second embodiment of the invention; and
- Figures 12 and 13 are graphic representations of two measurements of power irradiated by the supply cable of a dishwasher, respectively without and with an earthing arrangement provided according to the invention.

### Description of preferred embodiments of the invention

Reference to "*an embodiment*" or "*one embodiment*" in the framework of the present description is intended to indicate that a particular configuration, structure, or characteristic described in relation to the embodiment is comprised in at least one embodiment. Hence, phrases such as "*in an embodiment*" or "*in one embodiment*" and the like that may be present in various points of this description do not necessarily all refer to one and the same embodiment. Moreover, the particular configurations, structures, or characteristics may be combined in any adequate way in one or more embodiments. The references used herein are provided merely for convenience and do not define the sphere of protection or the scope of the embodiments.

It is moreover pointed out that in the sequel of the present description only the elements useful for an understanding of the invention will be described, taking for granted - for example - that the machine according to the invention comprises all the elements in themselves known for operation of a dish-washing machine, including an outer cabinet thereof, a user interface, a control system, electrical loads, etc.

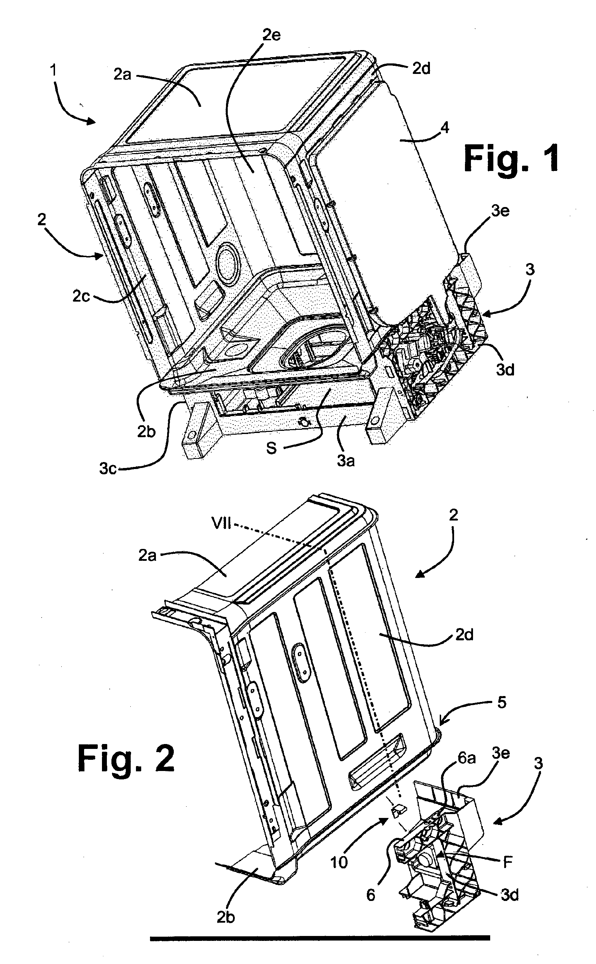

Represented schematically in Figure 1 is a dish-washing machine 1 according to the invention. The machine 1 is illustrated limitedly to the parts of immediate interest for an understanding of the present invention.

The machine 1 has a structure that comprises a wash tub 2 supported by a base 3. The base 3, made of electrically non-conductive material, for example an injection-moulded thermoplastic material, defines a housing space S, positioned within which are various functional components of the machine 1, amongst which a plurality of electrical loads, such as for example an electronic-control card, a washing pump, a discharge pump, a pressure switch, one or more solenoid valves, etc., not represented here for reasons of greater clarity of the drawings.

The wash tub 2 is of an overall known conception, and thus comprises an upper wall 2a, a lower wall 2b, and four peripheral walls. Visible in Figure 1 are just three peripheral walls of the tub 2, i.e., the left-hand and right-hand side walls, designated by 2c and 2d, and the rear wall 2e. The fourth peripheral wall of the tub 2, i.e., its front wall, is constituted by an inner shell of the door of the machine, here not represented (the so-called "counter-door"). The aforesaid walls are conveniently made of metal material, for example stainless steel. In the example illustrated, on the right-hand wall 2d a condenser device 4 is mounted, forming part of a system for drying the dishes: the presence of the aforesaid condenser device is not linked to the invention described hereinafter. Once again visible from Figure 1 it may be seen how the lower wall 2b of the tub 2 defines a central opening (not shown), where a collection sump is mounted (not represented), which integrates the filtering system of the machine, and connected to which in fluid communication are the intake branches of the aforesaid washing and discharge pumps.

Also the structure of the plastic base 3 has peripheral walls, and in particular a front wall 3a, two side walls 3c and 3d, and a rear wall 3e. Some of the peripheral walls of the base 3, and in particular at least the side walls 3c and 3d, preferentially have a boxlike structure, in particular open outwards, with stiffening ribs (not shown). Preferably, moreover, at least some of the peripheral walls of the base 3, and in the case in point the front wall 3a and the side walls 3c and 3d have openings that enable access to the housing space S, for example to facilitate assembly of components of the machine in the production stage or enable access thereto in the case of subsequent interventions of maintenance and/or repair. The aforesaid electronic control card is preferably mounted on the front wall 3a of the base 3.

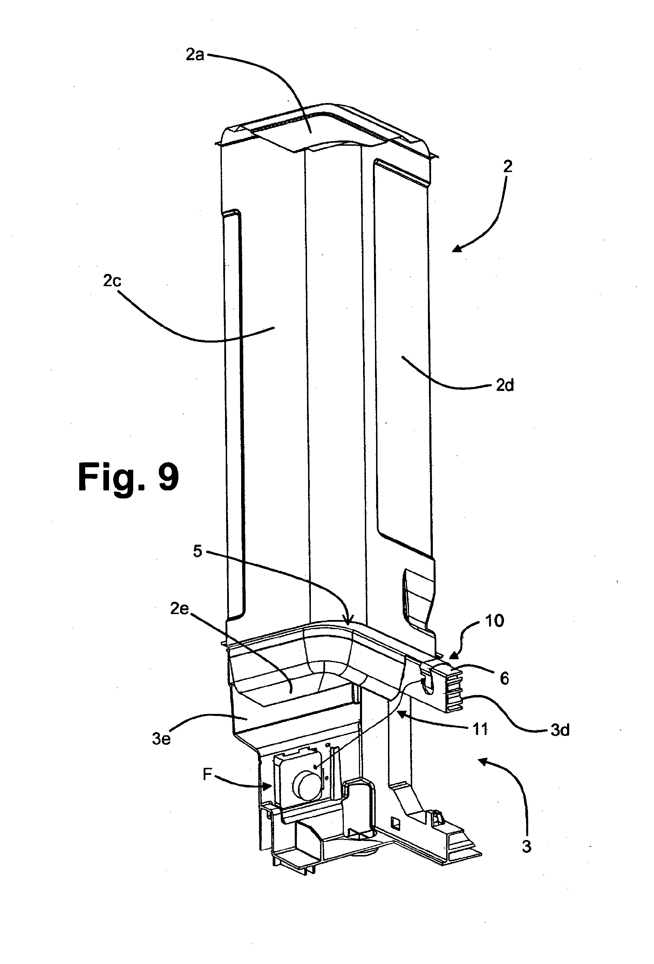

Preferably - and as may be seen, for example, in Figures 2, 9 and 10 - the lower wall 2b of the tub 2 has a generally flange-like portion projecting outwards, designated by 5, defined in a region of joining thereof with the peripheral walls 2c-2e. Said flange-like portion 5 defines a surface for resting of the tub 2 as a whole on the base 3. In the front part of the tub 2, the front edge of the lower wall 2b is shaped differently, also to enable opening of the door.

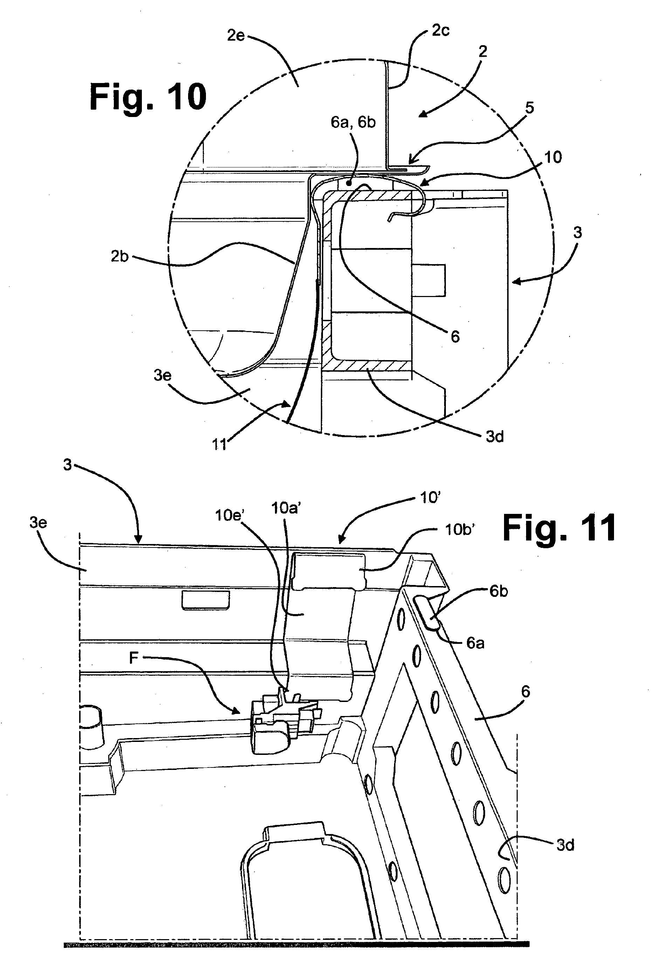

The tub 2 as a whole is, as has been said, supported by the base 3. Given that tub and base are made of relatively rigid materials, in order to prevent any transmission of vibrations, the contact between the two parts occurs via resting elements. In a preferred embodiment, provided between the upper face of the side walls 3c, 3d of the base 3 and the flange-like portion 5 of the lower wall 2b of the tub 2 are resting damping elements. In the example considered, integrally defined on the upper face of the side walls 3c and 3d are local seats for respective resilient resting members, for example in the form of blocks made of elastomer material. Visible in Figure 2 is one of said seats, designated by 6a, provided on the upper face 6 of the wall 3d (the wall 3c is built in a similar way). In Figure 2 the seat 6a is without the corresponding damping block, but a possible embodiment of the latter is visible in Figure 11, where it is designated by 6b. In the example represented, the flange-like portion 5 of the bottom wall 2b of the tub is not resting on the upper edge of the rear wall 3e of the base 3, which can thus have a relatively thin configuration: on said edge there are hence not provided seats similar to the one designated by 6a. Obviously, there is nothing in principle to rule out making also the rear wall 3e of adequate thickness, with the upper edge or face provided with local-resting elements for the tub.

In the machine 1 according to the invention, fixed to at least one of the peripheral walls 3a-3e of the base 3 is an anti-noise filter device or an EMC (electromagnetic compatibility) device, of the type referred to in the introductory part of the present description. In the preferred embodiment of the invention, the filter device, designated by F, has a casing, preferably made of plastic, which is secured to the rear wall 3e of the base 3, as may be seen, for example, in Figures 2, 8, and 9. As has been said, the device F is connected as last stage between the electrical circuit inside the machine and the external electrical mains supply so as to attenuate the components of disturbance that the machine tends to introduce into the mains supply. The device F thus provides a sort of interface between the internal electrical circuit of the machine 1 and its supply cable. Consequently, in the machine illustrated, the supply cable for connection to the domestic mains supply can conveniently penetrate into the machine from the rear part of the structure, in a point corresponding to the device F.

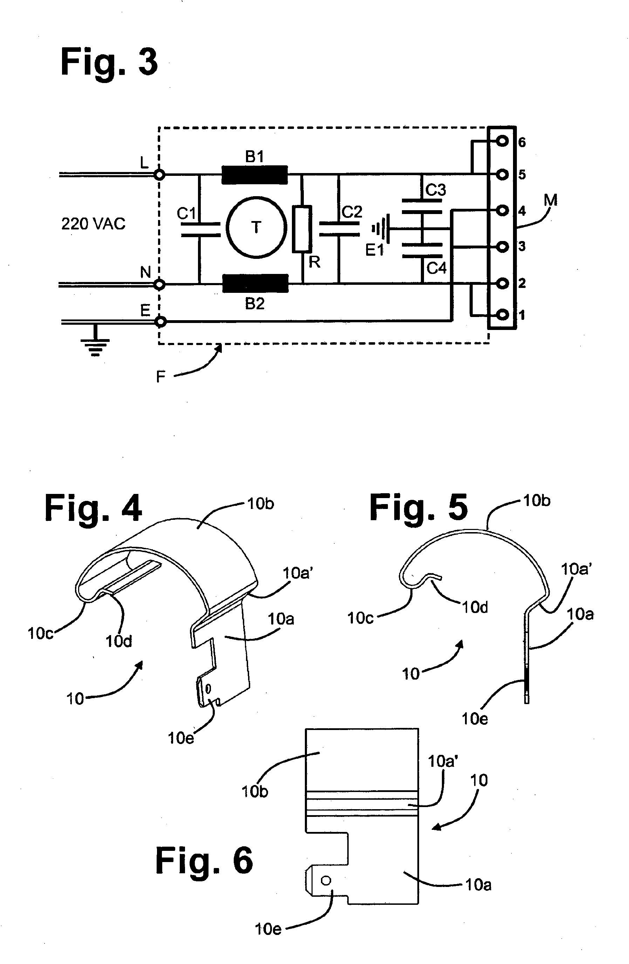

The filter device F has a circuit configuration generally known in the field and includes variously connected passive components. A possible embodiment in this sense is represented in Figure 3.

In Figure 3, L, N and E designate, respectively, the live conductor, the neutral conductor and the earth conductor of the supply cable of the machine 1, designed for connection to the external a.c. electric mains. In the example represented, the device F includes a capacitor C1, two induction coils B1 and B2 - connected respectively to live and neutral and wound on a toroidal core T, in mutual phase opposition - as well as a resistor R, a capacitor C2, and two further capacitors C3 and C4 set, respectively, between live and earth and between neutral and earth, E1 being the earth point in common, where the capacitors C1 and C2, the resistor R, and the set of the two capacitors C3 and C4 are connected in parallel between live and neutral. Designated by M is a multipolar connection, for connection, downstream of the device F, of the circuit inside the machine, comprising its electrical loads.

In general terms, in a two-wire connection (L and N) such as the one represented, a parasitic signal can be transmitted in differential mode and in common mode. As regards what is here of specific interest, the common-mode current traverses the two conductors in the same direction and with return through the earth via parasitic capacitances and inductances. In the filter device F exemplified, the capacitors C1 and C2 act as differential-mode filter, whereas the capacitors C3 and C4, together with the common-mode coil represented by the two induction coils B1 and B2 wound on the core T, form a common-mode filter.

The connection of the machine 1 to the earth of the domestic electrical wiring, accessible on the contact E present on the tripolar supply cable of the machine, has purposes of electrical safety and may be obtained by connecting E to the metal structure of the machine 1. In the machine 1, as occurs in known machines with a base made of plastic material, said safety earthing connection may be made by connecting the earth contact E of the supply cable to one of the hinges of the door (here not represented) provided in the front part of the machine, this hinge being in a condition of electrical conduction with other metal parts of the structure. The filter device F comprises, as per the known art, a terminal E1 for earthing the filter itself, E1 consequently being connected to the contact E of the supply cable. In this way, the terminal E1 of the filter F is connected also to the metal structure of the machine 1 by means of the aforesaid safety earthing connection.

The invention regards in particular improvement of the connection between the metal chassis of the machine 1 and the filter device F, in particular with the earth contact E1 of the filter F so as to render more effective filtering of components of common-mode disturbance present on the metal chassis or associated thereto.

In accordance with the present invention, the filter F then envisages an earth connection with the metal wash tub, which includes a metal strap having a contact portion that is interposed between the tub 2 and the base 3.

The metal strap, i.e., a metal conductor element having a generally laminar or platelike shape, constitutes a conductor with a sufficiently broad surface such as to present a low resistance also at high frequency and guarantee at the same time an extensive "metal on metal" contact. Merely by way of example, the strap may indicatively have a width comprised between 10 mm and 50 mm, preferably comprised between 20 mm and 30 mm.

Provision of a strap with a contact portion that is set between the tub 2 and the base 3 is also extremely advantageous in so far as, as in the preferred embodiment of the invention, it avoids the need for specific means of mechanical fixing of the strap itself to the tub 2. The fact that the contact portion of the metal strap is set between the tub and the base moreover guarantees a marked pressure of contact between the conductive elements (i.e. the tub and the strap).

In a particularly advantageous embodiment, the contact portion of the strap is an elastically deformable contact portion, which is kept in a condition of elastic compression by the tub 2 itself, which is supported by the base 3. In this way, the constancy of a good contact to the ground plane represented by the tub 2 is ensured, even in the presence of possible tolerances of installation of components of the machine and of its operating vibrations. Preferably, the metal strap is shaped to define integrally such an elastically deformable contact portion, to the advantage of simplicity and economy of construction. Very preferably, the strap defines integrally also an electrical terminal for connection to the filter device.

Illustrated in detail in Figures 4-6 is a possible embodiment of the aforesaid strap, designated as a whole by 10.

In the example, the strap 10 has a generally upright part 10a, at the top of which the aforesaid contact portion extends, designated as a whole by 10b, here having a generally curved profile in order to be elastically deformable. In the example, the upper end of the upright portion 10a has a bend outwards, in 10a", whilst the opposite end of the portion 10b is further curved inwards, in 10c, to define an engagement flap 10d. In the case exemplified, moreover, the strap 10 - and in particular its upright part 10a, has a connection portion, here defining integrally an electrical connector 10e, in particular a blade connector, which in the example is of a male type.

The strap 10 illustrated may be easily obtained starting from a strip of electrically conductive metal material, for example stainless steel, via simple operations of shearing and bending/deformation.

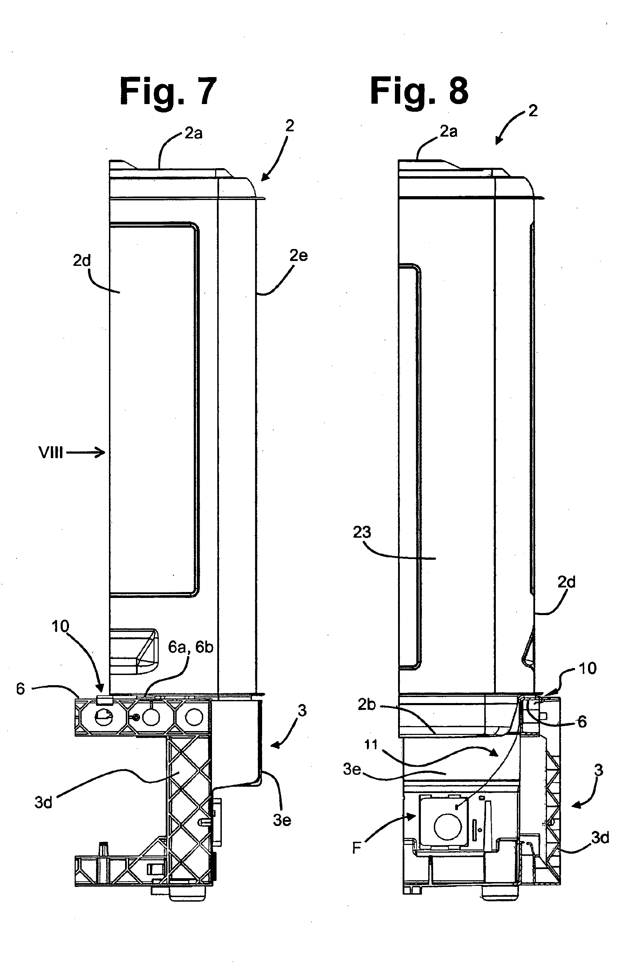

In this example of embodiment, the strap 10 is shaped approximately like a hook, this shape being advantageous for the purposes of installation of the strap itself on the base 3. More in particular - as may be seen in Figures 7-10 - the upper part of the strap 10 is mechanically coupled to the base 3 on the side wall 3d so that its contact portion 10b overlies a respective part of the upper face 6 of said wall (see Figure 10). As has been said previously, the side walls 3c and 3d of the base 3 preferably have a boxlike structure open outwards, and this facilitates engagement of the curved parts low and 10d at the outer edge of the aforesaid upper face 6, as may be seen clearly in Figure 10.

Of course, the contact part 10b of the strap 10 overlies the wall 3d in an area of its upper face 6 comprised between two resting elements 6a-6b (Figures 2, 7 and 10). During production of the machine, when the pre-assembled tub 2 is fitted on the base 3, the flange portion 5 of the bottom wall 2b comes to rest on the elements 6b, but before reaching said condition it will press the contact portion 10b from above, then keeping it in a condition of elastic compression, as will be appreciated from Figure 10.

For such an implementation, also the presence of the external bends 10a" of the upright part 10a is advantageous in so far as it makes it possible to provide a further area of contact of the strap 10 with the bottom wall 2b of the tub, and in particular with its generally convex part that descends from the flange portion 5, as may be clearly seen once again in Figure 10.

In the example of embodiment of Figures 2 and 3-10, the strap 10 is not connected directly to a terminal of the filter device F, said connection being obtained by means of an electric wire, designated by 11, preferably made of copper, not necessarily provided with insulating coating. As may be noted for example in Figures 2, 7 and 8, the area of engagement of the strap 10 to the wall 3d is quite close to the right-hand rear edge of the base 3, and also the point of fixing of the filter device F to the rear wall 3e is relatively close to the aforesaid edge. In this way, the wire 11 can have a relatively small length. The aforesaid characteristic reduces the risk of the wire 11 becoming itself a sort of antenna that picks up electromagnetic disturbance, injecting it into the system.

The position of installation illustrated for the filter device F is basically dictated by the fact that, in the example considered, the wall 3d of the base has an extensive through opening: it will be appreciated that in other embodiments the device F could be possibly fixed to the side wall 3d closer to the right-hand rear edge of the base 3; it will be appreciated that also with such an arrangement the supply cable can penetrate from the back of the base 3.

As has been said, the strap 10 preferably defines the blade terminal 10e, here of a male type, to which a commercial blade terminal of a female type can be coupled, provided at the upper end of the wire 11. The lower end of the wire 11 is connected to the filter device F, which is purposely equipped with connection terminals, of a type in itself known: for example, the device F may envisage (male or female) blade terminals of its own, to which a complementary terminal provided at the bottom end of the electric wire 11 is coupled.

Figure 11 illustrates a different embodiment of the earth connection of the filter of the device F, according to which the strap is connected to the device itself in a direct way, i.e., in the absence of an intermediate electric wire.

The strap, here designated by 10', is configured in such a way that its contact portion is set between a peripheral wall of the base 3 and the aforesaid generally convex portion of the bottom wall 2b of the tub 2.

In the case in point, the strap 10' is resting on the rear wall 3 e of the base 3 and its upright part 10a' is advantageously shaped so as to follow the profile of said rear wall, where here includes a step. As may be noted, in said embodiment, the strap does not have parts that overlie the upper edge or face of the rear wall 3e, and rather its encumbrance in height does not exceed that of said rear wall.

The contact portion, here designated by 10b', is also elastically deformable and belongs to an end part of the strap 10' bent substantially to form a V, i.e., bent back on itself. Also in this case, the lower end of the strap 10' may define integrally a connection portion 10e', for example shaped like an electrical terminal, for connection to a corresponding earth terminal of the device F. Preferably, there is not provided any particular mechanical means for fixing the strap 10' on the base 3. Possibly, the upright part 10a' of the strap could be glued to the wall 3e of the base 3, on its rear face.

It will be appreciated that the strap 10' has a shape even simpler than that of the strap 10 described previously, which can also be obtained via elementary operations of shearing and bending of a starting metal strip, such as a strip of stainless steel.

As may be appreciated, in the condition where the strap 10 is mounted on the base 3, the contact portion 10b' initially projects with a first inclination with respect to the terminal stretch of the upright part 10a'; when, then, the pre-assembled tub 2 is mounted on the base 3, the contact portion 10b' is pushed backwards by the convex portion of the bottom wall 2b of the tub 2, towards the upright part 10a' so as to be in a condition of elastic compression. As for the previous implementation, this guarantees extensive contact with marked pressure between the strap and the tub, suitable to provide an adequate connection between the tub and hence the metal structure of the machine and the earth contact of the filter F.

Practical tests conducted by the Applicant have made it possible to ascertain that the arrangement according to the invention enables a considerable increase in the efficiency of the common-mode filter, such as to enable elimination of one or more of the ferrites traditionally used along the wiring. As previously explained, the earth connection obtained via the strap 10 or 10' described is not a connection having purposes of electrical safety of the machine, for which there exists a purposely designed part of wiring (E), but it is a connection having the purpose of improving the behaviour of the anti-noise filter.

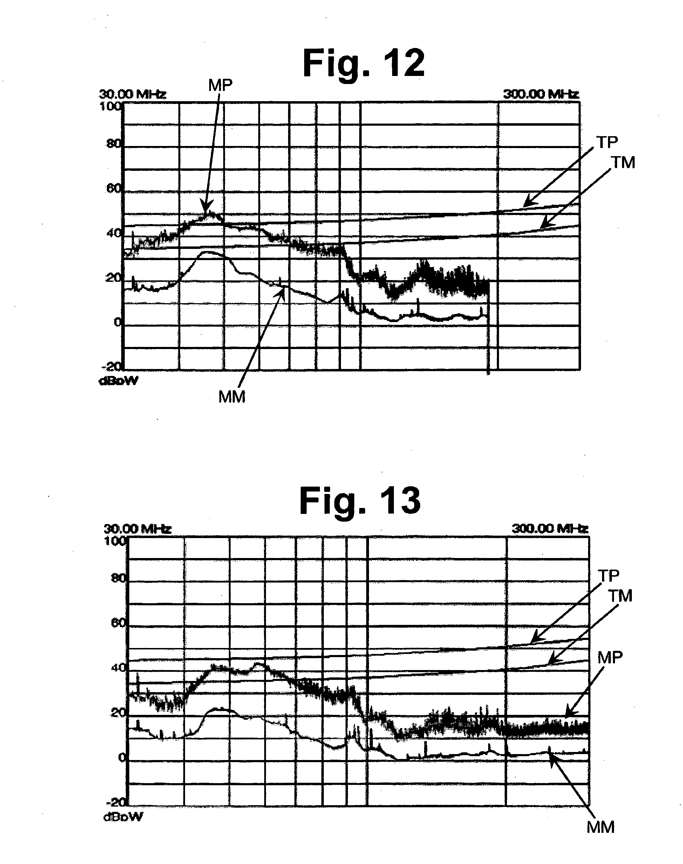

Figures 12 and 13 compare the results of two disturbance-power tests, carried out on one and the same machine provided with a filtering device of the type previously designated by F, in the absence of ferrites along the wiring. Figure 12 illustrates the case of a filter device F with just the safety earth connection E, and hence without a strap earthing, whilst Figure 13 illustrates the case of presence of further strap earthing. In the graphs, the line TP represents the quasi-peak limit, whereas the line TM represents the mean-value limit: according to standards, the resulting measurements, represented by the traces MP and MM, respectively, must always be below the respective limits TP and TM.

From a comparison between Figures 12 and 13, it may immediately be noted how the plot of the emission with the strap 10 connected (Figure 13) is shifted downwards, and in particular how around 48 MHz the mean value of the radio disturbance is attenuated by approximately 10 dBpW with respect to the case of absence of the strap (Figure 12).

The tests conducted by the present applicant have likewise made it possible to ascertain that the addition of the strap provided according to the invention is extremely similar, as effect, to the traditional addition of ferrites along the wiring. In both of the solutions there is a reduction of disturbance at output from the electrical household appliance. The difference lies in the fact that a ferrite eliminates disturbance in the point in which it is set, whereas the strap provided in accordance with the invention enables the filter F to work in a more efficient way and to reduce disturbance just before it exits from the electrical household appliance. The substantial difference between the ferrite and the strap is that the ferrite offers high impedance, typically, at lower frequencies as compared to those at which the strap starts to cause the filter F to work properly in frequency. Consequently, in practice, the strap provided in accordance with the invention can afford a considerable contribution in reducing to the bare minimum the number of ferrites to be applied to the wiring of the machine, if not even to their total removal.

It is clear that for the person skilled in the art numerous variants to the dishwashing machine described herein by way of example are possible, without thereby departing from the scope of the invention, as defined in the ensuing claims.

In accordance with one embodiment (not represented), the strap provided according to the invention is co-moulded in the base 3 or in one of the damping blocks or rubber elements 6b; i.e., it is partially embedded in the material of said base or block, but so that the corresponding contact portion with respect to the tub - and preferably also the portion for connection to the device F - remains on the outside of said material. It will be appreciated that said embodiment enables mechanical fixing of the strap with respect to the base 3 to be obtained directly, thus simplifying the process of assembly of the machine.

## Claims

1. A dishwasher having a structure that comprises a wash tub of metal material (2) supported by a base of electrically non-conductive material (3), the base (3) having a plurality of peripheral walls (3a-3e) that define a housing space (S) for a plurality of electrical loads that can be supplied via a supply cable (L, N, H) for connection to an a.c. electric mains, wherein between the supply cable (L, N, H) and the plurality of electrical loads a filter device (F) is provided, that includes an anti-noise filter (C3, C4, B1, B2, T), the filter device (F) being fixed to a wall (3e) of the base (3), **characterized in that** the anti-noise filter (C3, C4, B1, B2, T) has a connection for earthing of said wash tub made of metal material, including a metal strap (10; 10') having a contact portion (10b; 10b') that is interposed between the tub (2) and the base (3).

2. The dishwashers according to Claim 1, wherein the contact portion (10b; 10b') is elastically deformable and is kept by the tub (2) in a condition of elastic compression.

3. The dishwashers according to Claim 2, wherein the metal strap (10; 10') is shaped for defining integrally the elastically deformable contact portion (10b; 10b').

4. The dishwasher according to any one of the preceding claims, wherein the metal strap (10) has a connection portion (10e; 10e') for connection to the anti-noise filter (C3, C4, B1, B2, T).

5. The dishwasher according to Claim 4, wherein the metal strap (10) defines integrally the connection portion (10e; 10e'), the latter including an electrical terminal for connection to the anti-noise filter (C3, C4, B1, B2, T), in particular a blade terminal.

6. The dishwasher according to any one of the preceding claims, wherein the contact portion (10b) is interposed between an upper face (6) of a peripheral wall (3d) of the base (3) and a generally flange-like portion (5) defined by a lower wall (2b) of the tub (2).

7. The dishwasher according to any one of Claims 2 to 5, wherein the contact portion (10b') is interposed between a peripheral wall (3e) of the base (3) and a generally convex portion defined by a lower wall (2b) of the tub (2).

8. The dishwasher according to Claim 6, wherein an electric wire (11) extends between the metal strap (10) and the anti-noise filter (C3, C4, B1, B2, T).

9. The dishwasher according to Claim 6, wherein on said upper face (6) rest elements (6a, 6b) for said generally flange-like portion (5) are provided, in particular elements for local rest.

10. The dishwasher according to any one of the preceding claims, wherein the elastically deformable contact portion comprises a generally curved part (10b) of the metal strap (10).

11. The dishwasher according to any one of the preceding claims, wherein the elastically deformable contact portion (10b') belongs to an end part of the metal strap (10') that is substantially V-folded.

12. The dishwasher according to any one of the preceding claims, wherein the filter device (F) is secured to a rear wall (3e) of the base (3).

13. The dishwasher according to any one of the preceding claims, wherein the metal strap (10; 10') is co-moulded in at least one of the base (3) and a resilient member (6b) operatively interposed between the tub (2) and the base (3); i.e., it is partially embedded in a material forming said base or resilient member in such a way that at least the corresponding contact portion (10b; 10b') remains outside said material.

14. The dishwasher according to any one of the preceding claims, wherein at least one portion (10a"; 10') of the metal strap (10; 10') is shaped in accordance with a profile of a corresponding portion of the tub (2) and/or of the base (3).

## Patentansprüche

1. Geschirrspülmaschine mit einer Struktur, umfassend einen Waschbehälter aus einem Metallmaterial (2), welche von einem Sockel aus elektrisch nicht-leitendem Material (3) getragen wird, wobei der Sockel (3) eine Mehrzahl von Umfangswänden (3a-3e) aufweist, welche einen Gehäuseraum (S) für eine Mehrzahl von elektrischen Lasten definieren, welche mittels eines Versorgungskabels (L, N, H) zum Verbinden an ein Wechselstromnetz versorgt werden können, wobei zwischen dem Versorgungskabel (L, N, H) und der Mehrzahl von elektrischen Lasten eine Filtervorrichtung (F) bereitgestellt ist, welche einen Entstörfilter (C3, C4, B1, B2, T) umfasst, wobei die Filtervorrichtung (F) an einer Wand (3e) des Sockels (3) befestigt ist, **dadurch gekennzeichnet, dass** der Entstörfilter (C3, C4, B1, B2, T) einen aus einem Metallmaterial hergestellten Anschluss zum Erden des Waschbehälters aufweist, umfassend eine Metallspange (10; 10'), welche einen Kontaktabschnitt (10b; 10b') aufweist, welcher zwischen dem Behälter (2) und dem Sockel (3) angeordnet ist.

2. Geschirrspülmaschine nach Anspruch 1, wobei der Kontaktabschnitt (10b; 10b') elastisch verformbar ist und von dem Behälter (2) in einem Zustand elastischer Kompression gehalten wird.

3. Geschirrspülmaschine nach Anspruch 2, wobei die Metallspange (10; 10') zum integralen Definieren des elastisch verformbaren Kontaktabschnitts (10b; 10b') geformt ist.

4. Geschirrspülmaschine nach einem der vorhergehenden Ansprüche, wobei die Metallspange (10) einen Verbindungsabschnitt (10e; 10e') zum Verbinden mit dem Entstörfilter (C3, C4, B1, B2, T) aufweist.

5. Geschirrspülmaschine nach Anspruch 4, wobei die Metallspange (10) integral den Verbindungsabschnitt (10e; 10e') definiert, wobei letzterer einen elektrischen Anschluss zum Verbinden mit dem Entstörfilter (C3, C4, B1, B2, T), insbesondere einen Flachstecker, umfasst.

6. Geschirrspülmaschine nach einem der vorhergehenden Ansprüche, wobei der Kontaktabschnitt (10b) zwischen einer oberen Fläche (6) einer Umfangswand (3d) des Sockels (3) und einem von einer unteren Wand (2b) des Behälters (2) definierten, im Wesentlichen Flanschartigen Abschnitt (5) angeordnet ist.

7. Geschirrspülmaschine nach einem der Ansprüche 2 bis 5, wobei der Kontaktabschnitt (10b') zwischen einer Umfangswand (3e) des Sockels (3) und einem von einer unteren Wand (2b) des Behälters (2) definierten, im Wesentlichen konvexen Abschnitt angeordnet ist.

8. Geschirrspülmaschine nach Anspruch 6, wobei sich ein elektrischer Draht (11) zwischen der Metallspange (10) und dem Entstörfilter (C3, C4, B1, B2, T) erstreckt.

9. Geschirrspülmaschine nach Anspruch 6, wobei auf der oberen Fläche (6) Lagerelemente (6a, 6b) für den im Wesentlichen Flansch-artigen Abschnitt (5) bereitgestellt sind, insbesondere für lokales Lagern.

10. Geschirrspülmaschine nach einem der vorhergehenden Ansprüche, wobei der elastisch verformbare Kontaktabschnitt ein im Wesentlichen gebogenes Teil (10b) der Metallspange (10) umfasst.

11. Geschirrspülmaschine nach einem der vorhergehenden Ansprüche, wobei der elastisch verformbare Kontaktabschnitt (10b') einem im Wesentlichen V-förmig gefalteten Endteil der Metallspange (10') zugehörig ist.

12. Geschirrspülmaschine nach einem der vorhergehenden Ansprüche, wobei die Filtervorrichtung (F) an einer hinteren Wand (3e) des Sockels (3) gesichert ist.

13. Geschirrspülmaschine nach einem der vorhergehenden Ansprüche, wobei die Metallspange (10; 10') zusammengegossen ist mit wenigstens einem aus dem Sockel (3) und einem elastischen Element (6b), welches betriebsmäßig zwischen dem Behälter (2) und dem Sockel (3) angeordnet ist; d.h. es ist derart teilweise in ein Material eingebettet, welches den Sockel oder das elastische Element bildet, dass wenigstens der entsprechende Kontaktabschnitt (10b; 10b') außerhalb des Materials verbleibt.

14. Geschirrspülmaschine nach einem der vorhergehenden Ansprüche, wobei wenigstens ein Abschnitt (10a"; 10') der Metallspange (10; 10') in Übereinstimmung mit einem Profil eines entsprechenden Abschnitts des Behälters (2) oder/und des Sockels (3) geformt ist.

## Revendications

1. Lave-vaisselle comportant une structure qui comprend une cuve de lavage constituée d'un matériau métallique (2) supportée par une base constituée d'un matériau non conducteur électriquement (3), la base (3) présentant une pluralité de parois périphériques (3a-3e) qui définissent un espace de logement (S) destiné à une pluralité de composants électriques qui peuvent être alimentés par l'intermédiaire d'un câble d'alimentation (L, N, H) en vue d'une connexion avec un réseau électrique en courant alternatif, dans lequel entre le câble d'alimentation (L, N, H) et la pluralité des composants électriques un dispositif de filtrage (F) est prévu, lequel comporte un filtre antibruit (C3, C4, B1, B2, T), le dispositif de filtrage (F) étant fixé à une paroi (3e) de la base (3), **caractérisé en ce que** le filtre antibruit (C3, C4, B1, B2, T) possède une connexion de mise à la terre de ladite cuve de lavage constituée de matériau métallique, comportant un cavalier de connexion métallique (10 ; 10') ayant une partie de contact (10b ; 10b') qui est interposée entre la cuve (2) et la base (3).

2. Lave-vaisselle selon la revendication 1, dans lequel la partie de contact (10b ; 10b') peut se déformer élastiquement et est maintenue par la cuve (2) dans un état de compression élastique.

3. Lave-vaisselle selon la revendication 2, dans lequel le cavalier de connexion métallique (10 ; 10') est configuré pour définir solidairement la partie de contact déformable élastiquement (10b ; 10b').

4. Lave-vaisselle selon l'une quelconque des revendications précédentes, dans lequel le cavalier de connexion métallique (10) comporte une partie de connexion (10e ; 10e') en vue d'une connexion avec le filtre antibruit (C3, C4, B1, B2, T).

5. Lave-vaisselle selon la revendication 4, dans lequel le cavalier de connexion métallique (10) définit solidairement la partie de connexion (10e ; 10e'), cette dernière incluant une borne électrique destinée à une connexion avec le filtre antibruit (C3, C4, B1, B2, T), en particulier une borne à languette.

6. Lave-vaisselle selon l'une quelconque des revendications précédentes, dans lequel la partie de contact (10b) est interposée entre une face supérieure (6) d'une paroi périphérique (3d) de la base (3) et une partie généralement de type à rebord (5) définie par une paroi inférieure (2b) de la cuve (2).

7. Lave-vaisselle selon l'une quelconque des revendications 2 à 5, dans lequel la partie de contact (10b') est interposée entre une paroi périphérique (3e) de la base (3) et une partie généralement convexe définie par une paroi inférieure (2b) de la cuve (2).

8. Lave-vaisselle selon la revendication 6, dans lequel un fil électrique (11) s'étend entre le cavalier de connexion métallique (10) et le filtre antibruit (C3, C4, B1, B2, T).

9. Lave-vaisselle selon la revendication 6, dans lequel sur ladite face supérieure (6) des éléments d'appui (6a, 6b) destinés à ladite partie généralement de type à rebord (5) sont prévus, en particulier des éléments destinés à un appui local.

10. Lave-vaisselle selon l'une quelconque des revendications précédentes, dans lequel la partie de contact élastiquement déformable comporte une partie généralement incurvée (10b) du cavalier de connexion métallique (10).

11. Lave-vaisselle selon l'une quelconque des revendications précédentes, dans lequel la partie de contact élastiquement déformable (10b') appartient à une partie d'extrémité du cavalier de connexion métallique (10') qui est essentiellement replié en forme de V.

12. Lave-vaisselle selon l'une quelconque des revendications précédentes, dans lequel le dispositif de filtrage (F) est fixé à une paroi arrière (3e) de la base (3).

13. Lave-vaisselle selon l'une quelconque des revendications précédentes, dans lequel le cavalier de connexion métallique (10 ; 10') est co-moulé dans au moins l'une de la base (3) et d'un élément élastique (6b) interposé fonctionnellement entre la cuve (2) et la base (3) ; c'est-à-dire qu'il est partiellement incorporé dans un matériau formant ladite base ou ledit élément élastique de telle manière qu'au moins la partie de contact correspondante (10b ; 10b') reste à l'extérieur dudit matériau.

14. Lave-vaisselle selon l'une quelconque des revendications précédentes, dans lequel au moins une partie (10a" ; 10') du cavalier de connexion métallique (10 ; 10') est configurée en conformité avec un profil d'une partie correspondante de la cuve (2) et/ou de la base (3).
